# EUROPÄISCHE PATENTSCHRIFT

(11) **EP 2 306 536 B1**
(45) Veröffentlichungstag und Bekanntmachung des Hinweises auf die Patenterteilung: **12.11.2014**
(21) Anmeldenummer: 10178788.5
(22) Anmeldetag: 23.09.2010
(51) Int. Cl.: H01L 35/00, F24C 7/00, F24C 15/00

(54) **Haushaltsgerät, insbesondere Gargerät mit einer sich im Betrieb erwärmenden Komponente sowie Verfahren zum Betreiben eines Haushaltsgeräts mit einer sich im Betrieb erwärmenden Komponente**
Domestic appliance, in particular cooking device with a component that heats up during operation and method for operating a domestic appliance with a component that heats up during operation
Appareil ménager, notamment appareil de cuisson doté d'un composant chauffant en fonctionnement et procédé de fonctionnement d'un appareil ménager doté d'un composant chauffant en fonctionnement

(30) Priorität: 02.10.2009 DE 102009045293
(43) Veröffentlichungstag der Anmeldung: 06.04.2011
(73) Patentinhaber: BSH Bosch und Siemens Hausgeräte GmbH, 81739 München (DE)
(72) Erfinder: Reinwald, Eckehard, 85521, Ottobrunn (DE)

(56) Entgegenhaltungen:
- WO-A1-2010/043597
- WO-A2-2006/103613
- JP-A- 2003 274 680
- US-A1- 2005 034 716
- US-A1- 2006 172 245
- US-B1- 6 588 419

## Beschreibung

Die Erfindung betrifft ein Haushaltsgerät, welches als Gargerät ausgeführt ist mit einer sich im Betrieb erwärmenden Komponente, welche nach dem Abschalten eine Restwärme aufweist. Des Weiteren betrifft die Erfindung ein Verfahren zum Betreiben eines Haushaltsgeräts, welches als Gargeräts ausgefuhrt ist mit einer sich im Betrieb erwärmenden Komponente, welche nach dem Abschalten eine Restwärme erzeugt.

Hausgeräte, wie Backöfen, weisen Komponenten auf, die sich im Betrieb erwärmen. In diesem Zusammenhang sind beispielsweise die Backofenmuffel oder aber auch elektronische Komponenten und Motoren genannt. Zur Kühlung von elektronischen Bauteilen oder Motoren werden Gebläse eingesetzt. Diese sind jedoch mit elektrischer Energie zu versorgen und erzeugen darüber hinaus eine Geräuschbildung, die gegebenenfalls für einen Nutzer störend ist.

Aus der US 2009/002573 A1 sind Peltier-Elemente bekannt, die mit einer thermisch beaufschlagten Komponente verbunden sind und aufgrund einer Temperaturdifferenz elektrischen Strom erzeugen. Das Peltier-Element ist dabei mit zwei unterschiedlichen Temperaturen beaufschlagten Platten kontaktiert, um diese Temperaturdifferenz erzeugen zu können. Darüber hinaus ist aus der US 2008/0245352 A1 der Einsatz eines Peltier-Elements in einem Ofen, welcher mit Holz geheizt wird, bekannt. Auch hier wird das Peltier-Element einerseits mit einer warmen Platte andererseits mit einer kalten Platte kontaktiert, um aufgrund dieser Temperaturdifferenz elektrischen Strom zu erzeugen. Um die Temperaturdifferenz relativ groß zu gestalten, wird die kühlere Platte des Weiteren noch mit dem Gebläse gekühlt.

Aus der US 2005/034716 A1, der US 2006/0172245 A1, der US 6 588 419 B1, der JP 2003 274680 A und der WO 2006/103613 A2 sind Geräte bekannt, die Komponenten aufweisen, die sich im Betrieb erwärmen und eine Restwärme aufweisen, die dann durch einen thermoelektrischen Generator in elektrische Energie umwandelbar ist und elektrischen Verbrauchern zur Verfügung gestellt werden kann. Die nach dem Prioritätstag der vorliegenden Anmeldung veröffentlichte WO 2010/043597 A1 offenbart ein Elektrogerät, welches in einem Bereitschaftsbetrieb betrieben werden kann, und ebenfalls Komponenten aufweist, welche sich im Betrieb erwärmen und eine Restwärme aufweisen, die dann durch einen thermoelektrischen Generator in elektrische Energie umwandelbar ist, welche elektrischen Verbrauchern in dem Bereitschaftsbetrieb zur Verfügung gestellt werden kann.

Es ist Aufgabe der vorliegenden Erfindung, ein Hausgerät, insbesondere ein Gargerät, so auszugestalten, dass es energieeffizienter betrieben werden kann. Diese Aufgabe wird durch ein Haushaltsgerät, welches die Merkmale nach Anspruch 1 aufweist, und ein Verfahren, welches die Merkmale nach Anspruch 8 aufweist, gelöst.

Ein erfindungsgemäßes Haushaltsgerät, z.B. Gargerät, umfasst zumindest eine sich im Betrieb erwärmende Komponente, welche nach dem Abschalten eine Restwärme aufweist. Das Gargerät umfasst darüber hinaus eine Energierückgewinnungsvorrichtung, welche mit der Komponente thermisch gekoppelt ist und welche zur Umwandlung der Restwärme der Komponente in elektrische Energie ausgebildet ist. Diese erzeugte elektrische Energie ist zumindest anteilig nach dem Abschalten der Komponente an zumindest eine elektrische Verbrauchereinrichtung des Gargeräts bereitgestellt. Das Gargerät ist somit in spezifischer Ausgestaltung mit Komponenten und in spezifischen Betriebsphasen energieeffizienter betreibbar. Indem die Energierückgewinnungsvorrichtung vorgesehen ist, kann eine ohnehin erzeugte erste Energieform im Gargerät, nämlich Wärme, sinnvoll umgewandelt und in einer anderen Energieform zum Betrieb einer anderen Komponente bereitgestellt werden. Insbesondere ist im Hinblick auf das Energiemanagement und die Betriebsweise dies auch spezifisch dann erst nach dem Abschalten der Komponente durchgeführt, indem nämlich spezifisch die Restwärme der sich im Betrieb erwärmenden Komponente genutzt wird.

Ferner ist die erzeugte elektrische Energie in einem Stand-By-Betrieb, einem so genannten energiereduzierten Betrieb, des Haushaltsgeräts oder in einem Betriebszustand, in dem das Gargerät von einem externen Energieversorgungsnetz entkoppelt ist, an zumindest einem elektrischen Verbraucher der Verbrauchereinrichtung bereitstellbar. Gerade in diesen spezifischen Betriebsphasen kann somit nochmals Energie eingespart werden und gegebenenfalls sogar in Betriebsphasen, in denen bei herkömmlichen Gargeräten eine Entkopplung vom externen Energieversorgungsnetz nicht möglich oder nicht zulässig ist, dies nunmehr durchgeführt werden. Der geräteintern selbst erzeugte Anteil der elektrischen Energie, die aus der Restwärme durch die Energierückgewinnungsvorrichtung umgewandelt wird, ermöglicht somit auch ein schnelleres und gegebenenfalls in bisher nicht möglichen Betriebsphasen vorgesehenes vollständiges Entkoppeln des Gargeräts von dem Energieversorgungsnetz. Vorzugsweise ist das Gargerät ein Backofen und die sich im Betrieb erwärmende Komponente ist die Muffel und/oder ein die Muffel erwärmender Heizkörper. Wird lediglich die Muffel als eine derartige sich im Betrieb erwärmende Komponente berücksichtigt, so wird mit dem Abschalten der Komponente das Ende eines Zubereitungsprogramms, beispielsweise eines Backvorgangs, der elektronisch gesteuert wird, verstanden. In diesem Sinne wird dies dann auch im Hinblick auf das Abschalten des Heizkörpers, welcher die Muffel erwärmt, verstanden.

Gerade bei Backöfen kann somit ein besonders energieeffizienter Betrieb nunmehr ermöglicht werden und die relativ große Restwärme nach dem Abschalten eines Heizkörpers und/oder nach dem Beenden eines Zubereitungsprogramms, sinnvoll genutzt werden.

Insbesondere wird somit ein Gargerät bereitgestellt, bei dem dann, wenn eine Komponente, die sich im Betrieb erwärmt, nicht benötigt wird, diese im Nachfolgenden noch zur Verfügung stehende thermische Energie, genutzt wird, um eine elektrische Versorgung anderer Bauteile des Gargeräts in diesem abgeschalteten Zustand der sich im Betrieb erwärmenden Komponente, und insbesondere dann auch im nicht betriebenen Zustand des Gargeräts zu ermöglichen.

Vorzugsweise umfasst die Energierückgewinnungsvorrichtung zumindest ein Peltier-Element, welches mit der Komponente und einem weiteren Temperaturmedium thermisch gekoppelt ist und aufgrund der Temperaturdifferenz zwischen der Komponente und dem Temperaturmedium einen elektrischen Strom erzeugt.

Insbesondere ist die Energierückgewinnungsvorrichtung ein thermoelektrischer Generator.

Vorzugsweise ist die elektrische Verbrauchereinrichtung des Haushaltsgeräts mit einem Kühlluftgebläse ausgebildet, welches zumindest zum Kühlen eines Elektronikmoduls des Gargeräts vorgesehen ist. Dieses Kühlluftgebläse ist nach dem Abschalten der sich im Betrieb erwärmenden Komponente in einer Kühlluftgebläse-Nachlaufzeit zumindest anteilig mit der erzeugten elektrischen Energie versorgt. Üblicherweise ist in herkömmlichen Gargeräten vorgesehen, dass eine sich im Betrieb erwärmende Komponente, wie beispielsweise ein Heizkörper, eine Muffel eines Backofens usw. nach deren Abschalten oder nach dem Ende eines ablaufenden Zubereitungsprogramms, weiter gekühlt werden, indem dann noch das Kühlluftgebläse betrieben wird. Diese Phase, welche mit dem Abschalten der Komponente beginnt, wird als Kühlluftgebläse-Nachlaufzeit bezeichnet. Ist eine ausreichende Kühlung dieser dann abgeschalteten Komponente erreicht, wird dann auch das Kühlluftgebläse deaktiviert. Gerade in dieser Kühlluftgebläse-Nachlaufzeit wird die Energieversorgung des Kühlluftgebläses energieeffizienter und einsparender durchgeführt, da die Energiespeisung nicht mehr über das externe Versorgungsnetz vollumfänglich erfolgt, sondern zumindest anteilig über die Geräte intern erzeugte elektrische Energie durch die Energierückgewinnungsvorrichtung möglich ist.

Vorzugsweise ist vorgesehen, dass die Verbrauchereinrichtung eine im abgeschalteten Zustand des z:B. Gargeräts Informationen anzeigende Einheit, insbesondere eine Uhr, aufweist, welche nach dem Abschalten der Komponente mit der erzeugten elektrischen Energie versorgt ist. Derartige Anzeigeeinheiten können gargerätspezifisch in unterschiedlichster Form und zur Präsentation von unterschiedlichsten Informationen für einen Nutzer des Gargeräts ausgebildet sein. Die Uhr ist in diesem Zusammenhang lediglich ein Beispiel und soll nicht abschließend verstanden werden. Gerade dann, wenn das Gargerät nicht benötigt oder nicht betrieben wird, werden diese Informationen weiterhin angezeigt und die Energieversorgung zu dieser Anzeige kann somit quasi zumindest zeitweise ohne eine externe Netzversorgung erfolgen.

Vorzugsweise weist das Haushaltsgerät einen Energiespeicher auf, in den die erzeugte elektrische Energie speicherbar ist. Damit kann erreicht werden, dass diese umgewandelte und erzeugte elektrische Energie aus der Restwärme der sich im Betrieb erwärmenden Komponente nicht sofort wieder verbraucht werden muss, sondern dass diese auch zu späteren Zeitpunkten noch vorhanden und abgegeben werden kann.

Vorzugsweise ist nach dem Ende eines Backvorgangs und dem Abschalten zumindest eines Heizkörpers die Restwärme der Muffel durch die Energierückgewinnungsvorrichtung in elektrische Energie umwandelbar und das Peltier-Element ist vorzugsweise an einer Außenseite einer Muffeldecke angeordnet. Gerade diese spezifische Positionierung des Peltier-Elements ermöglicht eine besonders große Temperaturdifferenz, wenn dieses Peltier-Element darüber hinaus mit einem gegenüber der Muffeldecke kühleren Temperaturmedium, beispielsweise einer Gehäusewand des Gargeräts oder dergleichen thermisch gekoppelt ist. Da üblicherweise die Muffeldecke besonders warm ist und somit ein besonders großes Restwärmepotential bildet, ist somit die Energieeffizienz und die Ausbeute zur Erzeugung des elektrischen Stroms besonders hoch.

Bei einem erfindungsgemäßen Verfahren zum Betreiben eines Haushaltsgeräts, insbesondere Gargeräts mit einer sich im Betrieb erwärmenden Komponente wird nach dem Abschalten der Komponente und/oder nach dem Ende eines Zubereitungsprogramms eine Restwärme der Komponente erzeugt. Eine Energierückgewinnungsvorrichtung des Gargeräts wird mit der sich im Betrieb erwärmenden Komponente thermisch gekoppelt und die Restwärme der Komponente wird mit dieser Energierückgewinnungsvorrichtung in elektrische Energie umgewandelt, wobei diese erzeugte elektrische Energie zumindest anteilig nach dem Abschalten der Komponente an zumindest eine elektrische Verbrauchereinrichtung des Gargeräts bereitgestellt wird, und die erzeugte elektrische Energie in einem Stand-By-Betrieb des Gargeräts oder in einem Betriebszustand, in dem das Gargerät von einem externen Energieversorgungsnetz entkoppelt ist, an zumindest einen elektrischen Verbraucher der Verbrauchereinrichtung bedarfsabhängig durch eine Steuereinheit gesteuert bereitgestellt wird.

Vorzugsweise weist die elektrische Verbrauchereinrichtung des Haushaltsgeräts ein Kühlluftgebläse auf, welches zumindest zum Kühlen eines Elektronikmoduls des Gargeräts ausgebildet ist, wobei das Kühlluftgebläse nach dem Abschalten der Komponente in einer Kühlluftgebläse-Nachlaufzeit zumindest anteilig mit der erzeugten elektrischen Energie versorgt wird.

Vorzugsweise wird die elektrische Verbrauchereinrichtung mit einer im abgeschalteten Zustand des z.B. Gargeräts Informationen anzeigende Einheit, insbesondere eine Uhr, ausgebildet, welche nach dem Abschalten der Komponente mit der erzeugten elektrischen Energie versorgt wird.

Vorzugsweise wird das z.B. Gargerät mit einem Energiespeicher ausgebildet, in den die erzeugte elektrische Energie zumindest anteilig gespeichert wird.

Vorzugsweise ist das Haushaltsgerät ein Backofen und die Komponente eine Muffel und/oder ein Heizkörper des Gargeräts, wobei nach dem Ende eines Backvorgangs und dem Abschalten zumindest eines Heizkörpers die Restwärme der Muffel durch die Energierückgewinnungsvorrichtung in elektrische Energie umgewandelt wird und zumindest anteilig der Verbrauchereinrichtung bereitgestellt wird und/oder zumindest anteilig in einen Energiespeicher des Gargeräts gespeichert wird.

Vorteilhafte Ausführungen des erfindungsgemäßen Gargeräts sind als vorteilhafte Ausführungen des erfindungsgemäßen Verfahrens anzusehen.

Weitere Merkmale der Erfindung ergeben sich aus den Ansprüchen, den Figuren und der Figurenbeschreibung. Die vorstehend in der Beschreibung genannten Merkmale und Merkmalskombinationen, als auch die in der Figurenbeschreibung und/oder in den Figuren alleine gezeigten Merkmale und Merkmalskombinationen, sind nicht nur in der jeweils angegeben Kombination, sondern auch in anderen Kombinationen oder in Alleinstellung verwendbar, ohne den Rahmen der Erfindung zu verlassen.

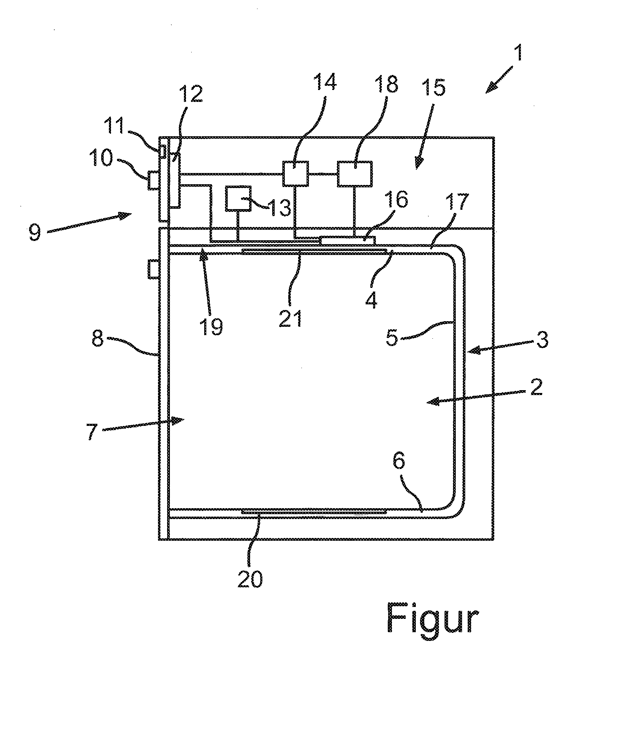

Ein Ausführungsbeispiel der Erfindung wird nachfolgend anhand einer schematischen Zeichnung näher erläutert. Die einzige Figur zeigt in vereinfachter Weise eine seitliche Schnittdarstellung durch ein Hausgerät, welches als Backofen 1, ausgebildet ist.

Der Backofen 1 weist einen Garraum 2 auf, welcher durch eine Muffel 3 begrenzt ist. Die Muffel 3 umfasst eine Decke 4, eine Rückwand 5 und einen Boden 6. Darüber hinaus umfasst die Muffel 3 nicht weiter gekennzeichnete Seitenwände. Frontseitig ist die Muffel 3 geöffnet und weist eine Beschickungsöffnung 7 auf, welche durch eine Tür 8 verschließbar ist. Darüber hinaus umfasst der Backofen 1 ein Bedienmodul 9, welches eine Mehrzahl von Bedienelementen 10 aufweist. Über das Bedienmodul 9 können Betriebsfunktionen und Betriebsparametereinstellungen durchgeführt werden. Das Bedienmodul 9 umfasst darüber hinaus eine Anzeigeeinheit zur Darstellung von Informationen, welche insbesondere auch dann angezeigt werden können, wenn der Backofen 1 nicht in Betrieb ist. Beispielsweise ist die Anzeigeeinheit eine Uhr 11.

Das Bedienmodul 9 umfasst darüber hinaus einen Schaltungsträger 12, auf dem elektronische Bauteile angeordnet sind. Sowohl der Schaltungsträger 12 als auch die Muffel 3 sind sich im Betrieb des Backofens 1 erwärmende Komponenten, insbesondere dann, wenn im Garraum 2 Lebensmittel zubereitet werden.

Der Backofen 1 umfasst darüber hinaus ein Kühlluftgebläse 13, welches zum Erzeugen eines Kühlluftstroms für den Schaltungsträger 12 ausgebildet und angeordnet ist. Das Kühlluftgebläse 13 ist mit einer Steuereinheit 14 verbunden und wird durch diese gesteuert. Darüber hinaus umfasst der Backofen 1 eine Energierückgewinnungsvorrichtung 15, welche ein Peltier-Element 16 aufweist. Das Peltier-Element 16 ist zum einen an der Außenseite 17 der Decke 4 der Muffel 3 angeordnet und mit dieser Muffel 3 thermisch kontaktiert. Darüber hinaus ist das Peltier-Element 16 mit einer gegenüber der Muffeldecke 4 auf niedrigerem Temperaturniveau sich befindenden Temperaturmedium, beispielsweise einer Gehäusewand des Backofens 1 oder dergleichen thermisch kontaktiert. Das Peltier-Element 16 ist aufgrund dieser thermischen Kontaktierungen einer Temperaturdifferenz ausgesetzt, wobei es dadurch aufgrund seiner Funktionsweise zur Erzeugung von elektrischer Energie, insbesondere elektrischen Strom, ausgebildet ist.

Der Backofen 1 umfasst darüber hinaus einen Energiespeicher 18, in dem die durch Umwandlung der Restwärme der Muffel 3 erzeugte elektrische Energie speicherbar ist.

Das Peltier-Element 16 ist darüber hinaus auch direkt mit dem Schaltungsträger 12 verbunden und darüber hinaus durch die Steuereinheit 14 steuerbar.

Die Energierückgewinnungsvorrichtung 15 ist als thermoelektrischer Generator ausgebildet, wobei aufgrund der Temperaturdifferenz zwischen dem Backrohr und einem kühleren Außenbereich, beispielsweise eine Frontblende oder dergleichen, in elektrische Spannung gewandelt wird.

Es ist vorgesehen, dass dann, wenn ein Backprogramm beendet ist und diesbezüglich die Steuereinheit 14 dieses Ende erkennt und dann ein oder mehrere Heizkörper 20 und 21 zum Erwärmen der Muffel 3 deaktiviert, die nach dem Abschalten erzeugte Restwärme der Muffel 3 in elektrische Energie umgewandelt wird und dadurch ein elektrischer Verbraucher einer elektrischen Verbrauchereinrichtung 19 mit dieser elektrischen Energie versorgt wird. Beispielhaft in Position und Formgebung ist ein erster Heizkörper 20 und ein zweiter Heizkörper 21 gezeigt.

Insbesondere ist vorgesehen, dass in einer Kühlluftgebläse-Nachlaufzeit, die mit dem Abschalten der Heizkörper 20 und 21 beziehungsweise mit dem Ende des Backvorgangs beginnt, diese erzeugte elektrische Energie dem Kühlluftgebläse 13 und/oder der Uhr 11 zur Verfügung gestellt wird. Dies bedeutet, dass dann, wenn das Gargerät für einen Zubereitungsvorgang nicht mehr benötigt wird und die entsprechenden Komponenten bereits deaktiviert sind, die erforderliche Kühlung, insbesondere des Schaltungsträgers 12 durch das Kühlluftgebläse 13 in der Kühlluftgebläse-Nachlaufzeit durchgeführt wird und die Energieversorgung des Kühlluftgebläses 13 dann zumindest anteilig über die von der Energierückgewinnungsvorrichtung 15 erzeugten geräteinternen Energie gedeckt wird. Vorzugsweise ist vorgesehen, dass gegebenenfalls mit diesem Ende des Backvorgangs der Backofen 1 vollständig von einem externen Energieversorgungsnetz N getrennt wird und die nach diesem Ende des Backvorgangs für elektrische Verbraucher erforderliche Energie vollständig über die Energierückgewinnungsvorrichtung 15 erzeugt wird.

Es kann auch vorgesehen sein, dass die von dem Peltier-Element 16 erzeugte elektrische Energie zumindest anteilig in dem Energiespeicher 18 zwischengespeichert wird. Diese kann dann bedarfsabhängig und situationsspezifisch auch später an elektrische Verbraucher abgegeben werden. Gerade die Uhr 11 kann mit dieser gespeicherten Energie dann auch noch versorgt werden, wenn das Gargerät längst ausgeschaltet ist und darüber hinaus auch bereits das Kühlluftgebläse 13 deaktiviert wurde, da die Kühlluftgebläse-Nachlaufzeit bereits beendet ist und insbesondere der Schaltungsträger 12 nach dem Ende des Backvorgangs und somit nach dem Abschalten der Heizkörper ausreichend gekühlt ist.

Das Peltier-Element 16 ist auch direkt mit dem Schaltungsträger 12 und/oder direkt mit dem Kühlluftgebläse 13 verbunden, so dass über die Steuereinheit 16 gesteuert die erzeugte elektrische Energie an dem Peltier-Element 16 direkt an diese Verbraucher abgebbar ist.

Sofort mit dem Ende des Backvorgangs kann somit der gesamte Backofen 1 auf einen Stand-By-Betrieb umgestaltet werden oder sogar eine vollständige Trennung vom Energieversorgungsnetz N erfolgen und die weitere Energieversorgung über die durch Umwandlung der Restwärme erzeugte elektrische Energie der Energierückgewinnungsvorrichtung 15 gedeckt werden.

### Bezugszeichenliste

- 1: Backofen
- 2: Garraum
- 3: Muffel
- 4: Decke
- 5: Rückwand
- 6: Boden
- 7: Beschickungsöffnung
- 8: Tür
- 9: Bedienmodul
- 10: Bedienelement
- 11: Uhr
- 12: Schaltungsträger
- 13: Kühlluftgebläse
- 14: Steuereinheit
- 15: Energierückgewinnungsvorrichtung
- 16: Peltier-Element
- 17: Außenseite
- 18: Energiespeicher
- 19: Verbrauchereinrichtung
- 20: Heizkörper
- 21: Heizkörper
- N: Energieversorgungsnetz

## Patentansprüche

1. Haushaltsgerät, welches als Gargerät ausgeführt ist, mit einer sich im Betrieb erwärmenden Komponente (3, 20, 21), welche nach dem Abschalten der Komponente (3, 20, 21) eine Restwärme aufweist, mit einer Energierückgewinnungsvorrichtung (15), welche mit der Komponente (3, 20, 21) thermisch gekoppelt ist und welche zur Umwandlung der Restwärme in elektrische Energie ausgebildet ist, **dadurch gekennzeichnet, dass** diese erzeugte elektrische Energie zumindest anteilig nach dem Abschalten der Komponente (3, 20, 21) an zumindest eine elektrische Verbrauchereinrichtung (19) des Haushaltsgeräts (1) bereitgestellt ist, und die erzeugte elektrische Energie in einem Stand-By-Betrieb des Haushaltsgeräts (1) oder in einem Betriebszustand, in dem das Haushaltsgerät (1) von einem externen Energieversorgungsnetz (N) entkoppelt ist, an zumindest einen elektrischen Verbraucher (11, 12, 13) der Verbrauchereinrichtung (19) bereitgestellt ist.

2. Haushaltsgerät nach Anspruch 1, **dadurch gekennzeichnet, dass** die Energierückgewinnungsvorrichtung (15) zumindest ein Peltier-Element (16) umfasst, welches mit der Komponente (3, 20, 21) und einem weiteren Temperaturmedium thermisch gekoppelt ist und aufgrund der Temperaturdifferenz zwischen der Komponente (3, 20, 21) und dem Temperaturmedium einen elektrischen Strom erzeugt.

3. Haushaltsgerät nach Anspruch 1 oder 2, **dadurch gekennzeichnet, dass** die Verbrauchereinrichtung (19) ein Kühlluftgebläse (13) zumindest zum Kühlen eines Elektronikmoduls (12) des Haushaltsgeräts (1) aufweist, welches nach dem Abschalten der Komponente (3, 20, 21) in einer Kühlluftgebläse-Nachlaufzeit zumindest anteilig mit der erzeugten elektrischen Energie versorgt ist.

4. Haushaltsgerät nach einem der vorhergehenden Ansprüche, **dadurch gekennzeichnet, dass** die Verbrauchereinrichtung (19) zumindest eine im abgeschalteten Zustand des Haushaltsgeräts (1) Informationen anzeigende Einheit, insbesondere eine Uhr (11), aufweist, welche nach dem Abschalten der Komponente (3, 20, 21) mit der erzeugten elektrischen Energie versorgt ist.

5. Haushaltsgerät nach einem der vorhergehenden Ansprüche, **dadurch gekennzeichnet, dass** ein Energiespeicher (18) ausgebildet ist, in den die erzeugte elektrische Energie speicherbar ist.

6. Haushaltsgerät nach einem der vorhergehenden Ansprüche, **dadurch gekennzeichnet, dass** das Haushaltsgerät ein Backofen (1) ist und die Komponente eine Muffel (3) und/oder einen Heizkörper (20, 21) umfasst.

7. Haushaltsgerät nach Anspruch 6, **dadurch gekennzeichnet, dass** nach dem Ende eines Backvorgangs und nach dem Abschalten zumindest eines Heizkörpers (20, 21) die Restwärme der Muffel (3) durch die Energierückgewinnungsvorrichtung (15) in elektrische Energie wandelbar ist und das Peltier-Element (16) an der Außenseite (17) einer Muffeldecke (4) angeordnet ist.

8. Verfahren zum Betreiben eines Haushaltsgeräts, welches als Gargerät (1) ausgeführt ist, mit einer sich im Betrieb erwärmenden Komponente (3, 20, 21), welche nach dem Abschalten der Komponente (3, 20, 21) eine Restwärme erzeugt, wobei eine Energierückgewinnungsvorrichtung (15) des Haushaltsgeräts (1) mit der Komponente (3, 20, 21) thermisch gekoppelt wird und mit welcher die Restwärme in elektrische Energie umgewandelt wird, **dadurch gekennzeichnet, dass** diese erzeugte elektrische Energie zumindest anteilig nach dem Abschalten der Komponente (3, 20, 21) an zumindest eine elektrische Verbrauchereinrichtung (19) des Haushaltsgeräts (1) bereitgestellt wird, und die erzeugte elektrische Energie in einem Stand-By-Betrieb des Haushaltsgeräts (1) oder in einem Betriebszustand, in dem das Haushaltsgerät (1) von einem externen Energieversorgungsnetz (N) entkoppelt ist, an zumindest einen elektrischen Verbraucher (11, 12, 13) der Verbrauchereinrichtung (19) bedarfsabhängig durch eine Steuereinheit (14) gesteuert bereitgestellt wird.

9. Verfahren nach Anspruch 8, **dadurch gekennzeichnet, dass** die Verbrauchereinrichtung (19) ein Kühlluftgebläse (13) zumindest zum Kühlen eines Elektronikmoduls (12) des Haushaltsgeräts (1) aufweist, welches nach dem Abschalten der Komponente (3, 20, 21) in einer Kühlluftgebläse-Nachlaufzeit zumindest anteilig mit der erzeugten elektrischen Energie versorgt wird.

10. Verfahren nach Anspruch 8 oder 9, **dadurch gekennzeichnet, dass** die Verbrauchereinrichtung (19) eine im abgeschalteten Zustand des Haushaltsgeräts (1) Informationen anzeigende Einheit, insbesondere eine Uhr (11), aufweist, welche nach dem Abschalten der Komponente (3, 20, 21) mit der erzeugten elektrischen Energie versorgt wird.

11. Verfahren nach einem der Ansprüche 8 bis 10,**dadurch gekennzeichnet, dass** ein Energiespeicher (18) ausgebildet ist, in den die erzeugte elektrische Energie zumindest anteilig gespeichert wird.

12. Verfahren nach einem der Ansprüche 8 bis 11, **dadurch gekennzeichnet, dass** das Haushaltsgerät ein Backofen (1) ist und die Komponente eine Muffel (3) und/oder einen Heizkörper (20, 21) umfasst, und nach dem Ende eines Backvorgangs und dem Abschalten zumindest eines Heizkörpers (20, 21) die Restwärme der Muffel (3) durch die Energierückgewinnungsvorrichtung (15) in elektrische Energie umgewandelt wird und zumindest anteilig der Verbrauchereinrichtung (19) bereitgestellt wird und/oder zumindest anteilig in einen Energiespeicher (18) gespeichert wird.

## Claims

1. Domestic appliance which is designed as a cooking appliance, with a component (3, 20, 21) which heats up in operation and which has a residual heat after the component (3, 20, 21) is switched off, with an energy recovery apparatus (15) which is thermally coupled to the component (3, 20, 21) and which is designed for converting residual heat into electrical energy, **characterised in that** this electrical energy generated is supplied at least partially after the component (3, 20, 21) has been switched off to at least one electrical consumer load device (19) of the domestic appliance (1), and the electrical energy generated is supplied in a stand-by mode of the domestic appliance (1) or in an operating state, in which the domestic appliance (1) is decoupled from an external energy supply grid (N), to at least one electrical consumer (11, 12, 13) of the consumer load device (19).

2. Domestic appliance according to claim 1, **characterised in that** the energy recovery apparatus (15) comprises at least one Peltier element (16) which is thermally coupled to the component (3, 20, 21) and another temperature medium, and because of the temperature difference between the component (3, 20, 21) and the temperature medium generates an electrical current.

3. Domestic appliance according to claim 1 or 2, **characterised in that** the consumer load device (19) has a cooling air fan (13) at least for cooling an electronic module (12) of the domestic appliance (1), which after the component (3, 20, 21) has been switched off is supplied in a cooling air fan follow-up period at least partially with the electrical energy generated.

4. Domestic appliance according to one of the preceding claims, **characterised in that** the consumer load device (19) has at least one unit, in particular a clock (11), which displays information in the switched-off state of the domestic appliance (1), and which after the component (3, 20, 21) is switched off is supplied with the electrical energy generated.

5. Domestic appliance according to one of the preceding claims, **characterised in that** an energy store (18) is embodied, in which the electrical energy generated can be stored.

6. Domestic appliance according to one of the preceding claims, **characterised in that** the domestic appliance is a baking oven (1) and the component comprises a muffle (3) and/or a heating element (20, 21).

7. Domestic appliance according to claim 6, **characterised in that** after the end of a baking operation and after at least one heating element (20, 21) has been switched off, the residual heat of the muffle (3) can be converted by the energy recovery apparatus (15) into electrical energy and the Peltier element (16) is arranged on the outside (17) of a muffle cover (4).

8. Method for operating a domestic appliance which is embodied as a cooking appliance (1), with a component (3, 20, 21) which heats up in operation and which generates a residual heat after the component (3, 20, 21) is switched off, wherein an energy recovery apparatus (15) of the domestic appliance (1) is thermally coupled to the component (3, 20, 21) and with which the residual heat is converted into electrical energy, **characterised in that** this electrical energy generated is supplied at least partially after the component (3, 20, 21) has been switched off to at least one electrical consumer load device (19) of the domestic appliance (1), and the electrical energy generated is supplied as required in a stand-by mode of the domestic appliance (1) or in an operating state, in which the domestic appliance (1) is decoupled from an external energy supply grid (N), to at least one electrical consumer (11, 12, 13) of the consumer load device (19) by a control unit (14) in a controlled manner.

9. Method according to claim 8, **characterised in that** the consumer load device (19) has a cooling air fan (13) at least for cooling an electronic module (12) of the domestic appliance (1), which after the component (3, 20, 21) has been switched off is supplied in a cooling air fan follow-up period at least partially with the electrical energy generated.

10. Method according to claim 8 or 9, **characterised in that** the consumer load device (19) has a unit, in particular a clock (11), which displays information in the switched-off state of the domestic appliance (1), and which after the component (3, 20, 21) is switched off is supplied with the electrical energy generated.

11. Method according to one of claims 8 to 10, **characterised in that** an energy store (18) is embodied, in which the electrical energy generated can at least partially be stored.

12. Method according to one of claims 8 to 11, **characterised in that** the domestic appliance is a baking oven (1) and the component comprises a muffle (3) and/or heating element (20, 21), and after the end of a baking operation and after at least one heating element (20, 21) has been switched off, the residual heat of the muffle (3) is converted by the energy recovery apparatus (15) into electrical energy and is supplied at least partially to the consumer load device (19) and/or is stored at least partially in an energy store (18).

## Revendications

1. Appareil ménager, mise en oeuvre en tant qu'appareil de cuisson, avec un composant (3, 20, 21) s'échauffant en cours de fonctionnement, qui présente une chaleur résiduelle après mise hors circuit du composant (3, 20, 21), avec un dispositif de récupération d'énergie (15), qui est couplé thermiquement avec le composant (3, 20, 21) et qui est prévu pour une conversion de la chaleur résiduelle en énergie électrique, **caractérisé en ce que** cette énergie électrique produite est mise à disposition d'au moins un appareil électrique consommateur (19) de l'appareil ménager (1) au moins de manière proportionnée après la mise hors circuit du composant (3, 20, 21), et l'énergie électrique produite est mise à disposition d'au moins un consommateur électrique (11, 12, 13) de l'appareil consommateur (19) dans un fonctionnement de veille de l'appareil ménager (1) ou dans un état de fonctionnement dans lequel l'appareil ménager (1) est découplé d'un réseau externe d'alimentation en énergie (N).

2. Appareil ménager selon la revendication 1, **caractérisé en ce que** le dispositif de récupération d'énergie (15) comprend au moins un élément Peltier (16), qui est couplé thermiquement avec le composant (3, 20, 21) et un autre milieu en température et produit un courant électrique en raison de la différence de température entre le composant (3, 20, 21) et le milieu en température.

3. Appareil ménager selon la revendication 1 ou 2, **caractérisé en ce que** l'appareil consommateur (19) présente une soufflante d'air de refroidissement (13) au moins destinée à refroidir un module électronique (12) de l'appareil ménager (1), qui est alimentée au moins de manière proportionnée avec l'énergie électrique produite pendant un temps d'arrêt de soufflante d'air de refroidissement après la mise hors circuit du composant (3, 20, 21).

4. Appareil ménager selon l'une quelconque des revendications précédents, **caractérisé en ce que** l'appareil consommateur (19) présente au moins une unité indiquant des informations, en particulier une heure (11), dans un état hors circuit de l'appareil ménager (1), ladite unité étant alimentée après la mise hors circuit du composant (3, 20, 21) avec l'énergie électrique produite.

5. Appareil ménager selon l'une quelconque des revendications précédents, **caractérisé en ce qu'**un accumulateur d'énergie (18) est prévu, dans lequel l'énergie électrique produite peut être stockée.

6. Appareil ménager selon l'une quelconque des revendications précédentes, **caractérisé en ce que** l'appareil ménager est un four de cuisson (1) et le composant comprend un moufle (3) et/ou un corps de chauffe (20, 21).

7. Appareil ménager selon la revendication 6, **caractérisé en ce que**, après la fin d'une action de cuisson et après la mise hors circuit d'au moins un corps de chauffe (20, 21), la chaleur résiduelle du moufle (3) peut être convertie en énergie électrique grâce au dispositif de récupération d'énergie (15) et l'élément Peltier (16) est agencé sur le côté extérieur (17) d'un couvercle de moufle (4).

8. Procédé de fonctionnement d'un appareil ménager, mis en oeuvre en tant qu'appareil de cuisson (1), avec un composant (3, 20, 21) s'échauffant en cours de fonctionnement, qui produit une chaleur résiduelle après la mise hors circuit du composant (3, 20, 21), un dispositif de récupération d'énergie (15) de l'appareil ménager (1) étant thermiquement couplé avec le composant (3, 20, 21) et avec lequel la chaleur résiduelle est convertie en énergie électrique, **caractérisé en ce que** cette énergie électrique produite est mise à disposition d'au moins un appareil électrique consommateur (19) de l'appareil ménager (1) au moins de manière proportionnée après la mise hors circuit du composant (3, 20, 21), et l'énergie électrique produite, dans un fonctionnement de veille de l'appareil ménager (1) ou dans un état de fonctionnement dans lequel l'appareil ménager (1) est découplé d'un réseau externe d'alimentation en énergie (N), est mise à disposition d'au moins un consommateur électrique (11, 12, 13) de l'appareil consommateur (19) de manière commandée en fonction d'un besoin grâce à une unité de commande (14).

9. Procédé selon la revendication 8, **caractérisé en ce que** l'appareil consommateur (19) présente une soufflante d'air de refroidissement (13) au moins destiné à un refroidissement d'un module électronique (12) de l'appareil ménager (1), qui est alimentée après la mise hors circuit du composant (3, 20, 21) pendant un temps d'arrêt de soufflante d'air de refroidissement au moins de manière proportionnée avec l'énergie électrique produite.

10. Procédé selon la revendication 8 ou 9, **caractérisé en ce que** l'appareil consommateur (19) présente une unité indiquant des informations, en particulier une heure (11), dans l'état de mise hors circuit de l'appareil ménager (1), qui est alimentée après la mise hors circuit du composant (3, 20, 21) avec l'énergie électrique produite.

11. Procédé selon l'une quelconque des revendications 8 à 10, **caractérisé en ce qu'**un accumulateur d'énergie (18) est prévu, dans lequel l'énergie électrique produite est stockée au moins de manière proportionnée.

12. Procédé selon l'une quelconque des revendications 8 à 11, **caractérisé en ce que** l'appareil ménager est un four de cuisson (1) et le composant comprend un moufle (3) et/ou un corps de chauffe (20, 21), et la chaleur résiduelle du moufle (3) est convertie en énergie électrique grâce au dispositif de récupération d'énergie (15) après la fin d'une action de cuisson et la mise hors circuit d'au moins un corps de chauffe (20, 21) et est mise à disposition de l'appareil consommateur (19) au moins de manière proportionnée et/ou est stockée dans un accumulateur d'énergie (18) au moins de manière proportionnée.
